# EUROPÄISCHE PATENTSCHRIFT

(11) **EP 1 107 656 B1**
(45) Veröffentlichungstag und Bekanntmachung des Hinweises auf die Patenterteilung: **03.10.2007**
(21) Anmeldenummer: 00126268.2
(22) Anmeldetag: 01.12.2000
(51) Int. Cl.: H05K 5/06

(54) **Elektrische Einrichtung**
Electrical device
Dispositif électronique

(30) Priorität: 09.12.1999 DE 19959384
(43) Veröffentlichungstag der Anmeldung: 13.06.2001
(73) Patentinhaber: BARTEC Componenten und Systeme GmbH, 97980 Bad Mergentheim (DE)
(72) Erfinder: Barlian, Reinhold, 97980 Bad Mergentheim (DE); Linström, Hans-Jürgen, Dr., 97990 Weikersheim-Schäftersheim (DE); Bach, Josef, 97922 Lauda-Gerlachsheim (DE)

(56) Entgegenhaltungen:
- FR-A- 1 174 709
- GB-A- 991 868
- GB-A- 2 036 449

## Beschreibung

Die Erfindung betrifft eine elektrische Einrichtung mit einem Gehäuse der Zündschutzart druckfeste Kapselung "d".

Aus der DIN EN 50018, Ausgabe Mai 1978, sind die technischen Anforderungen an die Gestaltung eines Gehäuses der Zündschutzart druckfeste Kapselung "d", insbesondere der Spalte, bekannt, wo die gegenüberliegenden Flächen von zwei Gehäuseteilen zusammenkommen.

Die FR-A-1 174 709 offenbart eine elektrische Einrichtung mit einem druckfest gekapselten Gehäuse, das mit einem Deckel gegen die Kraft eines explosionsartigen Gehäuseinnendrucks verschlossen ist. Zwischen dem Gehäuserand und dem Deckelrand ist ein zünddurchschlagsicherer Spalt gebildet. Für eine formschlüssige Verbindung der Gehäuse- und Deckelränder sind an zwei gegenüberliegenden Seitenrändern zwei auf Abstand zueinander angeordnete Profilklammern vorgesehen.

Die Aufgabe der Erfindung besteht darin, mit einfachen Mitteln eine platzsparende, zuverlässige Gehäusespaltverbindung zu erzielen.

Diese Aufgabe wird erfindungsgemäß durch die Merkmale des Anspruchs 1 gelöst.

Zweckmäßige Ausgestaltungen und Weiterbildungen der Erfindung sind durch die Merkmale der Unteransprüche gekennzeichnet.

Weitere Vorteile und wesentliche Einzelheiten der Erfindung sind der nachfolgenden Beschreibung und der Zeichnung zu entnehmen, die in schematischer Darstellung bevorzugte Ausführungsformen als Beispiel zeigt. Es stellen dar:
- FIG. 1: einen Teil eines erfindungsgemäßen Gehäuses mit einem planen oberen Gehäuseteil und einer Profilklammer mit gleichen Seitenstegen in einer geschnittenen Darstellung,
- FIG. 2: einen Teil eines erfindungsgemäßen Gehäuses mit einem haubenförmigen oberen Gehäuseteil und einer Profilklammer gemäß FIG. 1 in einer geschnittenen Darstellung,
- FIG. 3: einen Teil eines erfindungsgemäßen Gehäuses ähnlich der FIG. 1, jedoch mit einem stufenförmigen oberen Gehäuseteil und einer Profilklammer mit ungleich langen Seitenstegen in einer geschnittenen Darstellung,
- FIG. 4: einen Teil eines erfindungsgemäßen Gehäuses ähnlich der FIG. 1, jedoch mit einer zum Teil schwalbenschwanzförmig gestalteten Profilklammer in einer geschnittenen Darstellung,
- FIG. 5: einen rechtwinklig ausgeführten Eckbereich eines erfindungsgemäßen Gehäuses mit stumpf aufeinanderstoßenden Profilklammerenden,
- FIG. 6: einen rechtwinklig ausgeführten Eckbereich eines erfindungsgemäßen Gehäuses mit in einem 45° Winkel aneinanderstoßenden Profilklammerenden und
- FIG. 7: einen polygonartig ausgeführten Eckbereich eines erfindungsgemäßen Gehäuses mit schräg aneinanderstoßenden Profilklammerenden.

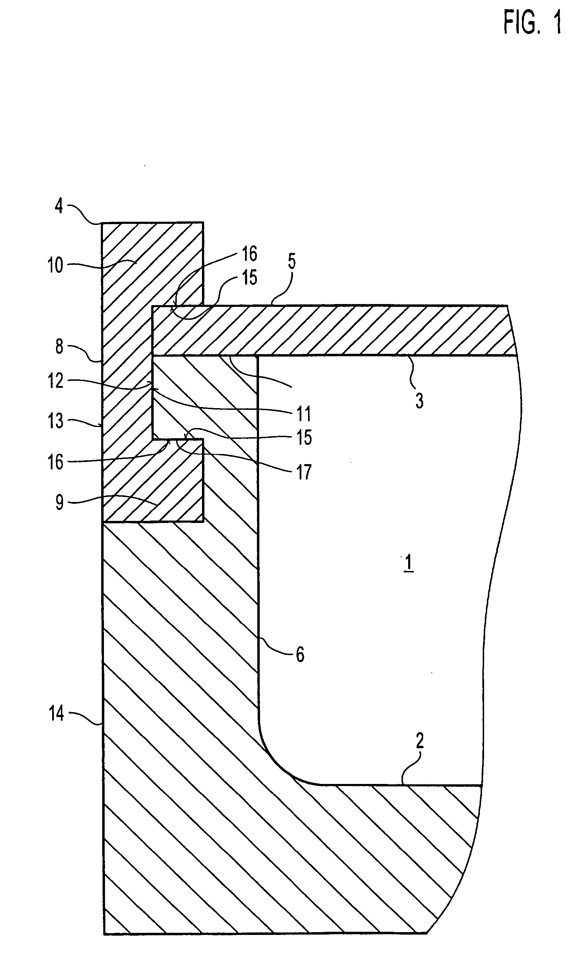

Das in der FIG. 1 dargestellte erfindungsgemäße Gehäuse 1 entspricht der Zündschutzart druckfeste Kapselung "d" und weist einen wannenförmigen Gehäuseteil 2, einen flachdeckelförmigen Gehäuseteil 3 und eine Profilklammer 4 auf. Der den Randbereich des Gehäuseteils 3 bildende Wandteil 5 liegt an der Stirnseite eines Wandteils 6 des Gehäuseteils 2 an. Die Profilklammer 4 verbindet die beiden Gehäuseteile 2, 3 miteinander, und zwar so, dass die Gehäuseteile 2, 3 auch im Falle einer durch ein zündfähiges Gemisch im Gehäuseinneren auftretenden Explosion fest zusammengehalten werden und zwischen den Wandteilen 5, 6 ein zünddurchschlagsicher Spalt 7 gebildet ist.

Der Querschnitt der Profilklammer 4 ist im wesentlichen etwa C-förmig gestaltet. Dazu weist die Profilklammer 4 einen Grundsteg 8 und zwei Seitenstege 9, 10 auf, die zueinander beabstandet und an ein und derselben Seite des Grundstegs 8 rechtwinklig zu diesem angeordnet sind. Der Grundsteg 8 und die Seitenstege 9, 10 selbst können zweckmäßig einen rechteckförmigen Querschnitt besitzen.

In einer bevorzugten Ausführung kann der Wandteil 6 des Gehäuseteils 2 eine Ausnehmung aufweisen, in die ein Teil des Grundstegs 8 und der Seitensteg 9 formschlüssig eingreifen. Dieser Eingriff kann vorteilhaft so gestaltet sein, dass eine Innenfläche 11 des Grundstegs 8 parallel zu einer Anlagefläche 12 des Gehäuseteils 2 und einer Stirnseite 18 des Gehäuseteils 3 liegt, wobei ein Abstand zwischen der Innenfläche 11 und der Anlagefläche 12 bzw. der Stirnseite 18 auftreten kann, der vorzugsweise kleiner als 1 mm ist. Zudem befindet sich der Grundsteg 8 der Profilklammer 4 derart tief in der Ausnehmung, dass eine Außenfläche 13 des Grundstegs 8 mit einer Außenseite 14 des Wandteils 6 eine gemeinsame Ebene bildet.

Außerdem kann es hinsichtlich der Sicherheit des Gehäuses 1 günstig sein, zwischen einer parallel zu dem zünddurchschlagsicheren Spalt 7 angeordneten Anschlagfläche 15 des Seitenstegs 9, 10 und einer Stützfläche 16 des Gehäuseteils 2, 3 einen zünddurchschlagsicheren Zusatzspalt 17 vorzusehen. Dieser zünddurchschlagsichere Zusatzspalt 17 kann bevorzugt kürzer ausgebildet sein als der zünddurchschlagsichere Spalt 7 zwischen den Gehäuseteilen 2, 3.

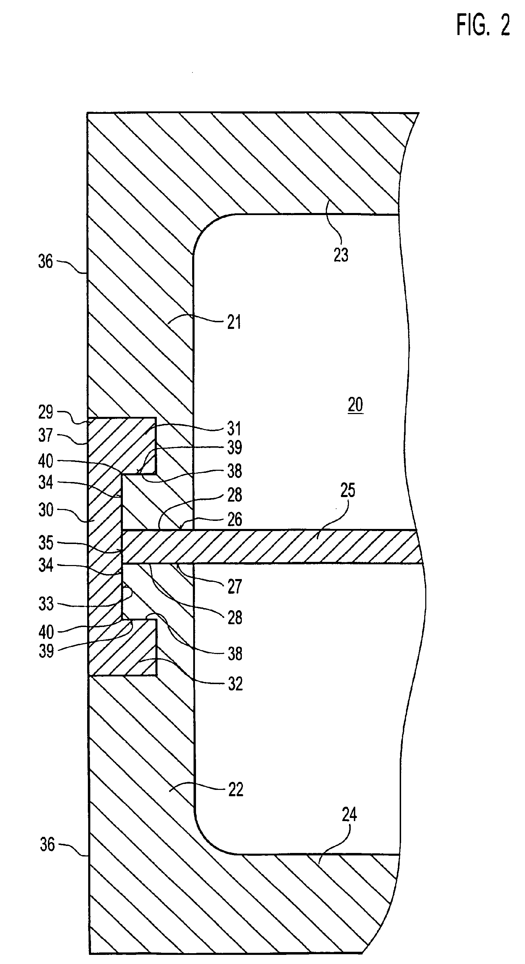

Bei dem in der FIG. 2 dargestellten druckfesten Gehäuse 20 befindet sich zwischen den Wandteilen 21, 22 der wannen- bzw. haubenförmigen Gehäuseteile 23, 24 eine Zusatzwand 25, die das Gehäuse 20 unterteilt. Der Abstand zwischen den einander zugewandten Stirnseiten der Wandteile 21, 22 ist nur etwas größer als die Dicke der Zusatzwand 25, so dass die Zusatzwand 25 weitgehend spielfrei in dem Abstandsbereich gehalten ist. Außerdem ist sowohl zwischen dem Wandteil 21 des einen Gehäuseteils 23 und der einen Seitenfläche 26 der Zusatzwand 25 als auch zwischen dem Wandteil 22 des anderen Gehäuseteils 24 und der anderen Seitenfläche 27 der Zusatzwand 25 je ein zünddurchschlagsicher Spalt 28 gebildet. Die Gehäuseteile 23, 24 werden durch die Profilklammer 29 derart formschlüssig verbunden, dass auch im Falle einer im Gehäuseinneren auftretenden Explosion ein fester Zusammenhalt gewährleistet ist. Die Profilklammer 29 ist wie die Profilklammer 4 des zuvor beschriebenen Ausführungsbeispiels im wesentlichen C-förmig ausgeführt und weist dazu einen im Querschnitt rechteckförmigen Grundsteg 30 und zwei ebenfalls rechteckförmige Seitenstege 31, 32 auf, die an ein und derselben Seite des Grundstegs 30 auf Abstand zueinander angeordnet sind.

Sowohl der Wandteil 21 als auch der Wandteil 22 weisen je eine Ausnehmung auf, in denen die Profilklammer 29 gelagert ist. Dabei kann die Innenfläche 33 des Grundstegs 30 ohne oder mit einem Abstand, der vorzugsweise weniger als 1 mm beträgt, parallel zu den Anlageflächen 34 der Gehäuseteile 23, 24 und einer Stirnfläche 35 der Zusatzwand 25 liegen. Die Profilklammer 29 ist in den Ausnehmungen der Wandteile 21, 22 derart gelagert, dass die Außenseiten 36 der Wandteile 21, 22 und die Außenfläche 37 des Grundstegs 30 eine gemeinsame Ebene bilden. Darüber hinaus kann zwischen den Anschlagflächen 38 der Seitenstege 31, 32 und den Stützflächen 39 der Gehäuseteile 23, 24 je ein zünddurchschlagsicherer Zusatzspalt 40 gebildet sein. Diese zünddurchschlagsicheren Zusatzspalte 40 erstrecken sich parallel zu den zünddurchschlagsicheren Spalten 28 und sind hier kürzer als letztere ausgebildet, können aber auch länger sein.

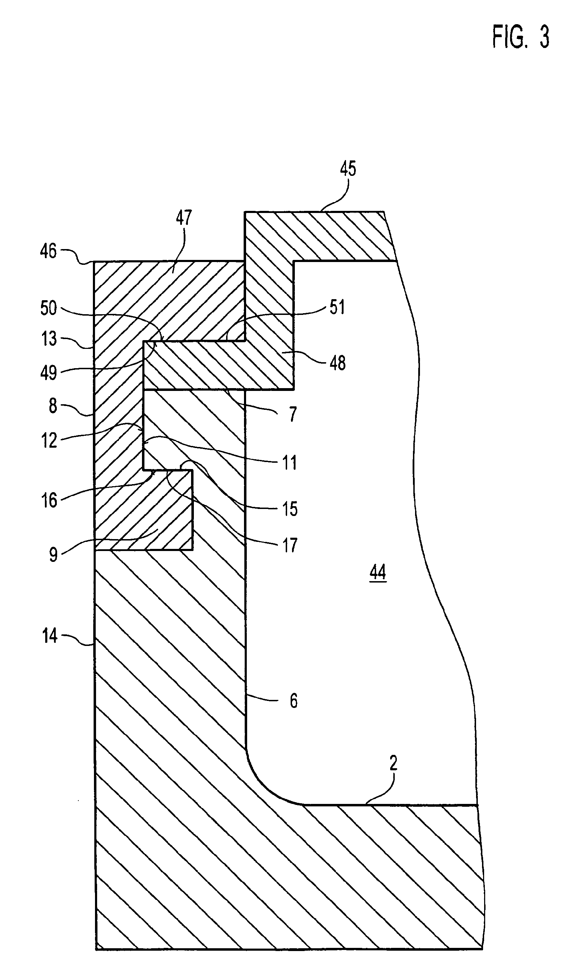

Das in der FIG. 3 dargestellte Gehäuse 44 ist ähnlich dem in der FIG. 1 dargestellten Ausführungsbeispiel. Allerdings ist der Randbereich des oberen Gehäuseteils 45 stufenförmig ausgebildet und die Profilklammer 46 weist an dem Grundsteg 8 den kurzen Seitensteg 9 und einen langen Seitensteg 47 auf. Dieser Seitensteg 47 übergreift den Wandteil 48 des Gehäuseteils 45, der auf dem Wandteil 6 des unteren Gehäuseteils 2 aufliegt. Dabei korrespondiert die Anschlagfläche 49 des Seitenstegs 47 mit der Stützfläche 50 des Wandteils 48, wodurch der zünddurchschlagsichere Zusatzspalt 51 gebildet ist, der beim vorliegenden Ausführungsbeispiel genauso lang ist wie der zünddurchschlagsichere Spalt 7 zwischen dem Wandteil 48 des oberen Gehäuseteils 45 und dem Wandteil 6 des unteren Gehäuseteils 2.

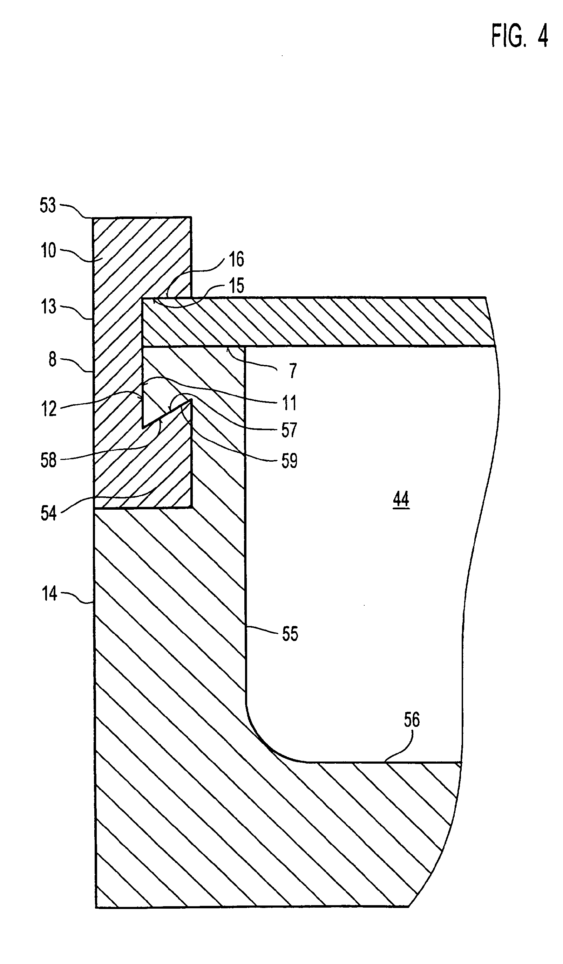

Das Gehäuse 52 der FIG. 4 ist ebenfalls ähnlich dem in der FIG. 1 dargestellten Ausführungsbeispiel. Allerdings weist die Profilklammer 53 einen schwalbenschwanzförmigen Seitensteg 54 auf, der in einer entsprechend schwalbenschwanzförmig gestalteten Ausnehmung des Wandteils 55 des unteren Gehäuseteils 56 gelagert ist. Somit verlaufen die Anschlagfläche 57 des Seitenstegs 54 sowie die Stützfläche 58 des Wandteils 55 und auch der zünddurchschlagsichere Zusatzspalt 59 schräg bzw. geneigt zu dem zünddurchschlagsicheren Spalt 7 zwischen dem oberen Gehäuseteil 3 und dem unteren Gehäuseteil 56.

Die Profilklammer 4, 29, 46, 53 kann ganzheitlich aus ein und demselben Material bestehen, das heißt, dass sowohl der Grundsteg 8, 30 als auch die jeweils zugehörigen Seitenstege 9, 10, 31, 32, 47, 54 materialeinheitlich einstückig ausgeführt sind. Um die Profilklammer 4, 29, 46, 53 gegen ein unbeabsichtigtes Lösen zu sichern, kann sie zweckmäßig an mindestens einem der Gehäuseteile 2, 3, 23, 24, 45,56 z.B mittels hier nicht dargestellten Gewindeschrauben festgelegt sein.

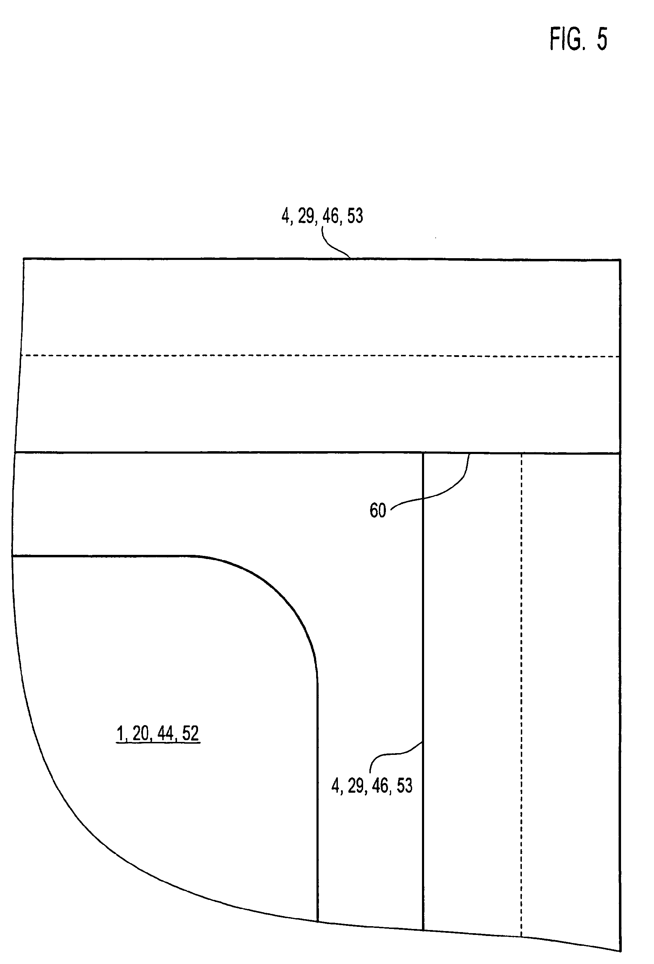

Der in der FIG. 5 dargestellte Gehäuseeckbereich ist rechtwinklig gestaltet, wobei zwei Enden der Profilklammern 4, 29, 46, 53 senkrecht stumpf aufeinanderstoßen, und zwar so, dass das Stirnende der in der Zeichnung vertikalen Profilklammer 4, 29, 46, 53 an einer Seitenfläche der in der Zeichnung horizontalen Profilklammer 4, 29, 46, 53 anliegt. Die Anlageebene ist plan, so dass ein ebener zünddurchschlagsicherer Profilspalt 60 gebildet ist.

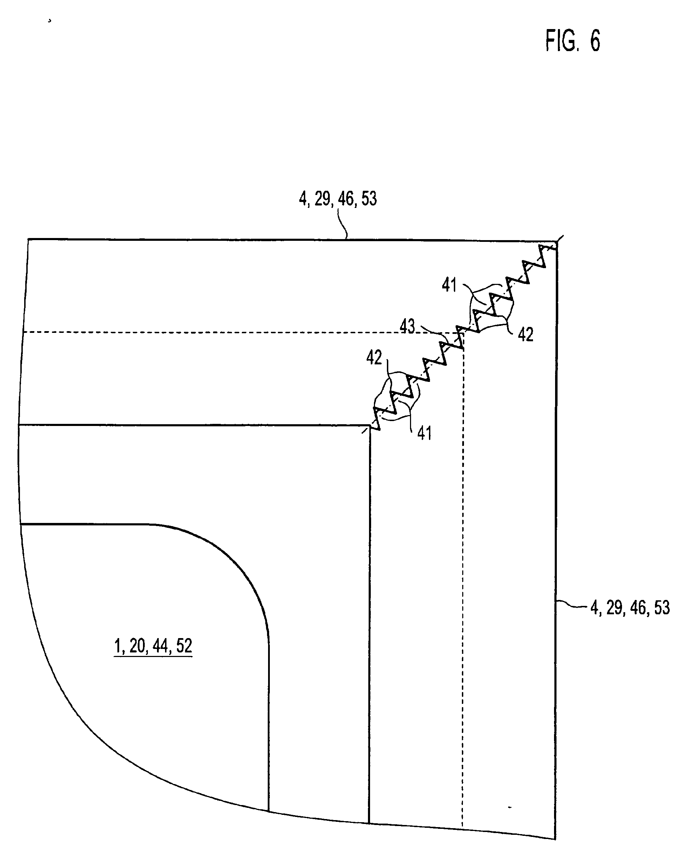

Der in der FIG. 6 dargestellte Gehäuseeckbereich ist ebenfalls rechtwinklig ausgeführt und es stoßen auch hier zwei Enden der Profilklammern 4, 29, 46, 53 senkrecht aufeinander, allerdings mit ihren zur jeweiligen Profilklammer-Längsrichtung schräg verlaufenden Stirnenden. Die aufeinanderstoßenden Stirnenden besitzen je ein Profil, das aus Vorsprüngen 41 und Rücksprüngen 42 gebildet ist, die bevorzugt als dreieckförmige Zähne mit dazwischenliegenden dreieckförmigen Zahnlücken ausgebildet sind. Es liegt im Rahmen der Erfindung, die Vorsprünge 41 und Rücksprünge 42 auch anders zu gestalten und zum Beispiel als rechteckförmige, trapezförmige oder sägezahnartige Zähne und Zahnlücken auszuführen. Die Vorsprünge 41 der einen Profilklammer 4, 29, 46, 53 greifen in die Rücksprünge 42 der anderen Profilklammer 4, 29, 46, 53 so ein, dass in einer 45°-Gehrung ein Zahnverbund mit einem zünddurchschlagsicheren Profilspalt 43 gebildet ist.

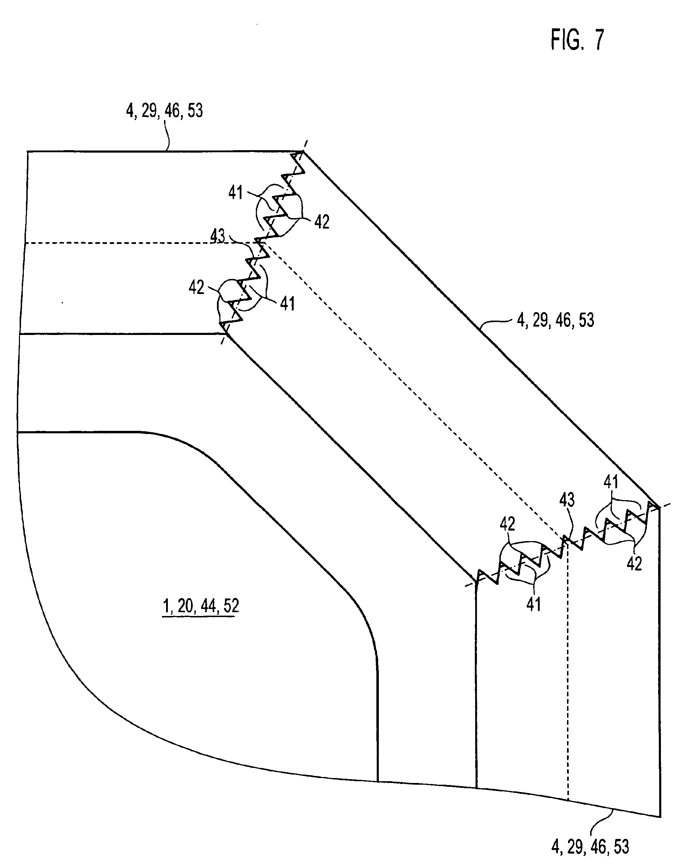

Der in der FIG. 7 dargestellte Eckbereich ist polygonartig gestaltet und besitzt zwei Zahnverbunde mit ineinandergreifenden Vorsprüngen 41 und Rücksprüngen 42 sowie zwei zünddurchschlagsicheren Profilspalten 43. Wie bei dem Ausführungsbeispiel der FIG. 6 sind die Vorsprünge 41 und Rücksprünge 42 auch hier als dreieckförmige Zähne mit dazwischenliegenden dreieckförmigen Zahnlücken ausgebildet.

## Patentansprüche

1. Elektrische Einrichtung mit einem Gehäuse (1, 20, 44, 52) der Zündschutzart druckfeste Kapselung "d", mindestens zwei Gehäuseteilen (2, 3, 23, 24, 45, 56), einem zwischen Wandteilen (5, 6, 21, 22, 48, 55) der Gehäuseteile (2, 3, 23, 24, 45, 56) vorgesehenen zünddurchschlagsicheren Spalt (7, 28) und die Gehäuseteile (2, 3, 23, 24, 45, 56) gegen die Kraft eines explosionsartigen Gehäuseinnendrucks formschlüssig verbindende Profilklammern (4, 29, 46, 53), **dadurch gekennzeichnet, dass** die Profilklammern (4, 29, 46, 53) an einem Gehäuseeckbereich mit zwei Enden derart aneinander stoßen, dass ein zünddurchschlagsicherer Profilspalt (43, 60) gebildet ist.

2. Einrichtung nach vorstehendem Anspruch, **dadurch gekennzeichnet, dass** die Profilklammer (4, 29, 46, 53) im Querschnitt etwa C-förmig ist.

3. Einrichtung nach einem der vorstehenden Ansprüche, **dadurch gekennzeichnet, dass** die Profilklammer (4, 29, 46, 53) einen Grundsteg (8,30) und zwei Seitenstege (9, 10, 31, 32, 47, 54) aufweist, wobei der eine Seitensteg (9, 32, 54) mit dem einen Gehäuseteil (2, 24, 56) und der andere Seitensteg (10, 31, 47) mit dem anderen Gehäuseteil (3, 23, 45) korrespondiert.

4. Einrichtung nach einem der vorstehenden Ansprüche, **dadurch gekennzeichnet, dass** die zueinander beabstandeten Seitenstege (9, 10, 31, 32, 47, 54) der Profilklammer (4, 29, 46, 53) an ein und derselben Seite des im Querschnitt bevorzugt rechteckförmigen Grundstegs (8, 30) winkelbildend, vorzugsweise rechtwinklig zu letzterem angeordnet sind.

5. Einrichtung nach einem der vorstehenden Ansprüche, **dadurch gekennzeichnet, dass** zwischen einer Anschlagfläche (15, 38, 49, 57) des Seitenstegs (9, 10, 31, 32, 47, 54) der Profilklammer (4, 29, 46, 53) und einer Stützfläche (16, 39, 50, 58) des Gehäuseteils (2, 3, 23, 24, 45, 56) ein zünddurchschlagsicherer Zusatzspalt (17, 40, 51, 59) gebildet ist.

6. Einrichtung nach vorstehendem Anspruch, **dadurch gekennzeichnet, dass** die Anschlagfläche (15, 38) des Seitenstegs (9, 10, 31, 32) der Profilklammer (4, 29) und die Stützfläche (16, 39) des Gehäuseteils (2, 3, 23, 24) sowie der zünddurchschlagsichere Zusatzspalt (17, 40) parallel zu dem zünddurchschlagsicheren Spalt (7, 28) angeordnet sind.

7. Einrichtung nach einem der vorstehenden Ansprüche 5 oder 6, **dadurch gekennzeichnet, dass** die Anschlagfläche (57) des Seitenstegs (54) der Profilklammer (53) und die Stützfläche (58) des Gehäuseteils (56) sowie der zünddurchschlagsichere Zusatzspalt (59) schräg zu dem zünddurchschlagsicheren Spalt (7, 28) angeordnet sind.

8. Einrichtung nach einem der vorstehenden Ansprüche 5 bis 7, **dadurch gekennzeichnet, dass** der zünddurchschlagsichere Zusatzspalt (17, 40, 59) zwischen der Anschlagfläche (15, 38, 57) des Seitenstegs (9, 10, 31, 32, 54) und der Stützfläche (16, 39, 58) des Gehäuseteils (2, 3, 23, 24, 56) kürzer ist als der zünddurchschlagsichere Spalt (7, 28) zwischen den beiden Gehäuseteilen (2, 3, 23, 24, 45).

9. Einrichtung nach einem der vorstehenden Ansprüche 5 bis 8, **dadurch gekennzeichnet, dass** die Länge des zünddurchschlagsicheren Zusatzspaltes (51) zwischen der Anschlagfläche (49) des Seitenstegs (47) und der Stützfläche (50) des Gehäuseteils (45) gleich oder größer ist als der zünddurchschlagsichere Spalt (7) zwischen den beiden Gehäuseteilen (2, 45).

10. Einrichtung nach einem der vorstehenden Ansprüche, **dadurch gekennzeichnet, dass** mindestens ein Teil der Profilklammer (4, 29, 46, 53) in einer Ausnehmung des Gehäuseteils (2, 23, 24) gelagert ist.

11. Einrichtung nach einem der vorstehenden Ansprüche 3 bis 10, **dadurch gekennzeichnet, dass** eine Außenfläche (13, 37) des Grundstegs (8, 30) der Profilklammer (4, 29, 46, 53) mit einer Außenseite (14, 36) mindestens eines der Gehäuseteile (2, 23, 24, 56) im Wesentlichen eine gemeinsame Ebene bildet.

12. Einrichtung nach einem der vorstehenden Ansprüche 3 bis 11, **dadurch gekennzeichnet, dass** eine dem Gehäuse (1, 20, 44, 52) zugewandte Innenfläche (11, 33) des Grundstegs (8, 30) der Profilklammer (4, 29, 46, 53) parallel zu einer Anlagefläche (12, 34) des Gehäuseteils (2, 3, 23, 24, 56) angeordnet ist.

13. Einrichtung nach einem der vorstehenden Ansprüche 3 bis 12, **dadurch gekennzeichnet, dass** zwischen der Innenfläche (11, 33) des Grundstegs (8, 30) der Profilklammer (4, 29, 46, 53) und der Anlagefläche (12, 34) des Gehäuseteils (2, 23, 24, 56) ein Abstand gebildet ist, der bevorzugt kleiner als 1 mm ist.

14. Einrichtung nach einem der vorstehenden Ansprüche, **dadurch gekennzeichnet, dass** zwischen den beiden Wandteilen (21, 22) des Gehäuses (20) eine Zusatzwand (25) angeordnet ist.

15. Einrichtung nach vorstehendem Anspruch, **dadurch gekennzeichnet, dass** der zünddurchschlagsichere Spalt (28) zwischen dem Wandteil (21, 22) des Gehäuses (20) und einer Seitenfläche (26, 27) der Zusatzwand (25) gebildet ist.

16. Einrichtung nach einem der vorstehenden Ansprüche 14 oder 15, **dadurch gekennzeichnet, dass** eine Stirnfläche (35) der Zusatzwand (25) an die Innenfläche (33) der Profilklammer (29) angrenzt.

17. Einrichtung nach einem der vorstehenden Ansprüche, **dadurch gekennzeichnet, dass** die zwei Enden der Profilklammern (4, 29, 46, 53) senkrecht stumpf aufeinander stoßen, wobei das Stirnende der einen Profilklammer (4, 29, 46, 53) an einer Seitenfläche der anderen Profilklammer (4, 29, 46, 53) plan anliegt und der zünddurchschlagsichere Profilspalt (60) eben ist.

18. Einrichtung nach einem der vorstehenden Ansprüche, **dadurch gekennzeichnet, dass** an mindestens einem Ende der einen Profilklammer (4, 29, 46, 53) und an mindestens einem Ende der anderen Profilklammer (4, 29, 46, 53) je ein aus Vorsprüngen (41) und Rücksprüngen (42) gebildetes Profil gebildet ist, wobei die Vorsprünge (41) der einen Profilklammer (4, 29, 46, 53) in die Rücksprünge (42) der anderen Profilklammer (4, 29, 46, 53) eingreifen und dazwischen der zünddurchschlagsichere Profilspalt (43) besteht.

19. Einrichtung nach vorstehendem Anspruch, **dadurch gekennzeichnet, dass** die Vorsprünge (41) und Rücksprünge (42) der Profilklammer (4, 29, 46, 53) als Zähne und Zahnlücken ausgebildet sind.

20. Einrichtung nach Anspruch 19, **dadurch gekennzeichnet, dass** die Zähne und Zahnlücken dreieckförmig ausgebildet sind.

21. Einrichtung nach Anspruch 19, **dadurch gekennzeichnet, dass** die Zähne und Zahnlücken rechteckförmig, trapezförmig oder sägezahnartig ausgeführt sind.

22. Einrichtung nach einem der vorstehenden Ansprüche, **dadurch gekennzeichnet, dass** der zünddurchschlagsichere Profilspalt (43) in einem Profilklammer-Eckbereich als 45°-Gehrung ausgebildet ist.

23. Einrichtung nach einem der vorstehenden Ansprüche, **dadurch gekennzeichnet, dass** der Profilklammer-Eckbereich polygonförmig ist und mindestens zwei zünddurchschlagsichere Profilspalte (43) aufweist.

24. Einrichtung nach einem der vorstehenden Ansprüche 3 bis 23, **dadurch gekennzeichnet, dass** die Profilklammer (4, 29, 46, 53) mit dem Grundsteg (8, 30) und den Seitenstegen (9, 10, 31, 32, 47, 54) materialeinheitlich einstückig ausgeführt ist.

25. Einrichtung nach einem der vorstehenden Ansprüche, **dadurch gekennzeichnet, dass** die Profilklammer (4, 29, 46, 53) an mindestens einem der Gehäuseteile (2, 3, 23, 24, 45, 56) unverlierbar festgelegt ist.

## Claims

1. Electric device with a housing (1, 20, 44, 52) of the ignition protection pressure resistant capsule type "d", at least two housing parts (2, 3, 23, 24, 45, 56), an ignition spark resistant gap (7, 28) envisaged between wall sections (5, 6, 21, 22, 48, 55) of the housing parts (2, 3, 23, 24, 45, 56) and connecting profile clamps (4, 29, 46, 53) against the force of an explosion like internal housing pressure by means of form closure, **characterised in that** the profile clamps (4, 29, 46, 53) abut against each other with two ends in a housing corner area in such a way that an ignition spark resistant profile gap (43, 60) is formed.

2. Device according to the preceding Claim, **characterised in that** the cross-section of the profile clamp (4, 29, 46, 53) is approximately C-shaped.

3. Device according to one of the preceding Claims, **characterised in that** the profile clamp (4, 29, 46, 53) comprises a base bridge (8, 30) and two side bridges (9, 10, 31, 32, 47, 54), whereby one side bridge (9, 32, 54) corresponds with one housing part (2, 24, 56) and the other side bridge (10, 31, 47) with the other housing part (3, 23, 45).

4. Device according to one of the preceding Claims, **characterised in that** the side bridges (9, 10, 31, 32, 47, 54) of the profile clamp (4, 29, 46, 53) arranged at a distance from each other are positioned on the same side of the base bridge (8, 30) with a preferably rectangular cross-section forming an angle, preferably a right angle with the latter.

5. Device according to one of the preceding Claims, **characterised in that** an ignition spark resistant further gap (17, 40, 51, 59) is formed between an abutment surface (15, 38, 48, 57) of the side bridge (9, 10, 31, 32, 47, 54) of the profile clamp (4, 29, 46, 53) and a support surface (16, 39, 50, 58) of the housing part (2, 3, 23, 24, 45, 56).

6. Device according to the preceding Claims, **characterised in that** the abutment surface (15, 38) of the side bridge (9, 10, 31, 32) of the profile clamp (4, 29) and the support surface (16, 39) of the housing part (2, 3, 23, 24) as well as the ignition spark resistant further gap (17, 40) are positioned parallel with the ignition spark resistant gap (17, 28).

7. Device according to one of the preceding Claims 5 or 6, **characterised in that** the abutment surface (57) of the side bridge (54) of the profile clamp (53) and the support surface (58) of the housing part (56) as well as the ignition spark resistant further gap (59) are arranged diagonally in relation to the ignition spark resistant gap (7, 28).

8. Device according to one of the preceding Claims 5 to 7, **characterised in that** the ignition spark resistant further gap (17, 40, 59) between the abutment surface (15, 38, 57) of the side bridge (9, 10, 31, 32, 54) and the support surface (16, 39, 58) of the housing part (2, 3, 23, 24, 56) is shorter than the ignition spark resistant gap (7, 28) between the two housing parts (2, 3, 23, 24, 45).

9. Device according to one of the preceding Claims 5 to 8, **characterised in that** the length of the ignition spark resistant further gap (51) between the abutment surface (49) of the side bridge (47) and the support surface (50) of the housing part (45) is equal to or larger than the ignition spark resistant gap (7) between the two housing parts (2, 45).

10. Device according to one of the preceding Claims, **characterised in that** at least a part of the profile clamp (4, 29, 46, 53) is positioned in a recess of the housing part (2, 23, 24).

11. Device according to one of the preceding Claims 3 to 10, **characterised in that** an outer surface (13, 37) of the base bridge (8, 30) of the profile clamp (4, 29, 46, 53) substantially forms a common surface with an outer side (14, 36) of at least one of the housing parts (2, 23, 24, 56).

12. Device according to one of the preceding Claims 3 to 11, **characterised in that** an inner surface (11, 33) of the base bridge (8, 30) of the profile clamp (4, 29, 46, 53) facing the housing (1, 20, 44, 52) is positioned parallel with an abutment surface (12, 34) of the housing part (2, 3, 23, 24, 56).

13. Device according to one of the preceding Claims 3 to 12, **characterised in that** a gap of preferably less than 1 mm is formed between the inner surface (11, 33) of the base bridge (8, 30) of the profile clamp (4, 29, 46, 53) and the abutment surface (12, 34) of the housing part (2, 23, 24, 56).

14. Device according to one of the preceding Claims, **characterised in that** an additional wall (25) is located between the two wall parts (21, 22) of the housing (20).

15. Device according to the preceding Claim, **characterised in that** the ignition spark resistant gap (28) is formed between the wall part (21, 22) of the housing (20) and a side surface (26, 27) of the further wall (25).

16. Device according to one of the preceding Claims 14 or 15, **characterised in that** a facing surface (35) of the further wall (25) borders into the inner surface (33) of the profile clamp (29).

17. Device according to one of the preceding Claims, **characterised in that** the two ends of the profile clamps (4, 29, 46, 53) meet vertically at a right angle, whereby the facing end of one profile clamp (4, 29, 46, 53) abuts in a planar fashion against a side surface of the other profile clamp (4, 29, 46, 53), and **in that** the ignition spark resistant profile gap (60) is level.

18. Device according to one of the preceding Claims, **characterised in that** one profile formed from projections (41) and recesses (42) each is formed on at least one end of one profile clamp (4, 29, 46, 53) and on at least one end of the other profile clamp (4, 29, 46, 53), whereby the projections (41) of one profile clamp (4, 29, 46, 53) engage the recesses (42) of the other profile clamp (4, 29, 46, 53), and the ignition spark resistant profile gap (43) exists between the same.

19. Device according to the preceding Claim, **characterised in that** the projections (41) and the recesses (42) of the profile clamp (4, 29, 46, 53) take the form of teeth and tooth profile gaps.

20. Device according to Claim 19, **characterised in that** the teeth and tooth profile gaps are of a triangular shape.

21. Device according to Claim 19, **characterised in that** the teeth and tooth profile gaps are of a rectangular, trapezoidal, or a zigzag shape.

22. Device according to one of the preceding Claims, **characterised in that** the ignition spark resistant profile gap (43) is formed in a profile clamp corner area in the form of a 45° mitre joint.

23. Device according to one of the preceding Claims, **characterised in that** the profile clamp corner area is polygon-shaped and comprises at least two ignition spark resistant profile gaps (43).

24. Device according to one of the preceding Claims 3 to 23, **characterised in that** the profile clamp (4, 29, 46, 53) is formed from one single piece of the same material with the base bridge (8, 30) and the side bridges (9, 10, 31, 32, 47, 54).

25. Device according to one of the preceding Claims, **characterised in that** the profile clamp (4, 29, 46, 53) is affixed to at least one of the housing parts (2, 3, 23, 24, 45, 56) and is impossible to lose.

## Revendications

1. Dispositif électrique comprenant un boîtier (1, 20, 44, 52) d'encapsulation « d » résistante à la pression de type protection anti-étincelle, au moins deux parties de boîtier (2, 3, 23, 24, 45, 56), une fente (7, 28) anti-décharge d'étincelle prévue entre des parties de paroi (5, 6, 21, 22, 48, 55) des parties de boîtier (2, 3, 23, 24, 45, 46), et des pinces profilées (4, 29, 46, 53) reliant par complémentarité de formes les parties de boîtier (2, 3, 23, 24, 45, 46) à l'encontre de la force d'une pression intérieure de boîtier de type explosive,
**caractérisé en ce que**
les pinces profilées (4, 29, 46, 53) ont deux extrémités qui se rencontrent au niveau d'une zone de coin du boîtier de manière à former une fente profilée (43, 60) anti-décharge d'étincelle.

2. Dispositif selon la revendication précédente,
**caractérisé en ce que**
la pince profilée (4, 29, 46, 53) est approximativement en forme de C en coupe transversale.

3. Dispositif selon l'une des revendications précédentes,
**caractérisé en ce que**
la pince profilée (4, 29, 46, 53) présente une barrette de base (8, 30) et deux barrettes latérales (9, 10, 31, 32, 47, 54), la première barrette latérale (9, 32, 54) correspondant à la première partie de boîtier (2, 24, 56) tandis que l'autre barrette latérale (10, 31, 47) correspond à l'autre partie de boîtier (3, 23, 45).

4. Dispositif selon l'une des revendications précédentes,
**caractérisé en ce que**
les barrette latérales (9, 10, 31, 32, 47, 54) de la pince profilée (4, 29, 46, 53), écartées l'une de l'autre, sont disposées d'un seul et même côté de la barrette de base (8, 30) de préférence rectangulaire en coupe transversale, en formant un angle par rapport à celle-ci, de préférence perpendiculairement à celle-ci.

5. Dispositif selon l'une des revendications précédentes,
**caractérisé en ce qu'**
entre une surface de butée (15, 38, 49, 57) de la barrette latérale (9, 10, 31, 32, 47, 54) de la pince profilée (4, 29, 46, 53) et une surface d'appui (16, 39, 50, 58) de la partie de boîtier (2, 3, 23, 24, 45, 56) est formée une fente supplémentaire (17, 40, 51, 59) anti-décharge étincelle.

6. Dispositif selon la revendication précédente,
**caractérisé en ce que**
la surface de butée (15, 38) de la barrette latérale (9, 10, 31, 32) de la pince profilée (4, 29) et la surface d'appui (16, 39) de la partie de boîtier (2, 3, 23, 24) ainsi que la fente supplémentaire (17, 40) anti-décharge d'étincelle sont parallèles à la fente (7, 28) anti-décharge d'étincelle.

7. Dispositif selon l'une des revendications précédentes 5 ou 6,
**caractérisé en ce que**
la surface de butée (57) de la barrette latérale (54) de la pince profilée (53) et la surface d'appui (58) de la partie de boîtier (56) ainsi que la fente supplémentaire (59) anti-décharge d'étincelle sont inclinées l'oblique par rapport à la fente (7, 26) anti-décharge d'étincelle.

8. Dispositif selon l'une des revendications précédentes 5 à 7,
**caractérisé en ce que**
la fente (17, 40, 59) anti-décharge d'étincelle entre la surface de butée (15, 38, 57) de la barrette latérale (9, 10, 31, 32, 54) et la surface d'appui (16, 39, 58) de la partie de boîtier (2, 3, 23, 24, 56) est plus courte que la fente (7, 28) anti-décharge étincelle entre les deux parties de boîtier (2, 3, 23, 24, 45).

9. Dispositif selon l'une des revendications précédentes 5 à 8,
**caractérisé en ce que**
la longueur de la fente supplémentaire (51) anti-décharge d'étincelle entre la surface de butée (49) de la barrette latérale (47) et la surface d'appui (50) de la partie de boîtier (45) est égale ou supérieure à celle de la fente (7) anti-décharge d'étincelle entre les deux parties de boîtier (2, 45).

10. Dispositif selon l'une des revendications précédentes,
**caractérisé en ce qu'**
au moins une partie de la pince profilée (4, 29, 46, 53) est logée dans un évidement de la partie de boîtier (2, 23, 24).

11. Dispositif selon l'une des revendications précédentes 3 à 10,
**caractérisé en ce qu'**
une surface extérieure (13, 37) de la barrette de base (8, 30) de la pince profilée (4, 29, 46, 53) forme pratiquement un plan commun avec un côté extérieur (14, 36) d'au moins l'une des parties de boîtier (2, 23, 24, 56).

12. Dispositif selon l'une des revendications précédentes 3 à 11,
**caractérisé en ce qu'**
une surface intérieure (11, 33), tournée vers le boîtier (1, 20, 44, 52), de la barrette de base (8, 30) de la pince profilée (4, 29, 46, 53) est parallèle à une surface d'appui (12, 34) de la partie de boîtier (2, 3, 23, 24, 56).

13. Dispositif selon l'une des revendications précédentes 3 à 12,
**caractérisé par**
un écart de préférence inférieur à 1 mm entre la surface intérieure (11, 33) de la barrette de base (8, 30) de la pince profilée (4, 29 46, 53) et la surface d'appui (12, 34) de la partie de boîtier (2, 23, 24, 56).

14. Dispositif selon l'une des revendications précédentes,
**caractérisé par**
une paroi supplémentaire (25)entre les deux parties de paroi (21, 22) du boîtier (20).

15. Dispositif selon la revendication précédente,
**caractérisé en ce que**
la fente (28) anti-décharge d'étincelle est formée entre la partie de paroi (21, 22) du boîtier (20) et une surface latérale (26, 27) de la paroi supplémentaire (25).

16. Dispositif selon l'une des revendications précédentes 14 ou 15,
**caractérisé en ce qu'**
une surface frontale (35) de la paroi supplémentaire (5) est adjacente à la surface intérieure (33) de la pince profilée (29).

17. Dispositif selon l'une des revendications précédentes,
**caractérisé en ce que**
les deux extrémités des pinces profilées (4, 29, 46, 53) se rencontrent perpendiculairement de manière tronquée, l'extrémité frontale de la première pince profilée (4, 29, 46, 53) reposant à plat contre une surface latérale de l'autre pince profilée (4, 29, 46, 53), et la fente (60) anti-décharge d'étincelle étant plane.

18. Dispositif selon l'une des revendications précédentes,
**caractérisé en ce qu'**
au moins une extrémité de la première pince profilée (4, 29, 46, 53) et au niveau au moins une extrémité de l'autre pince profilée (4, 29, 46, 53) ont chacune un profil formé de saillies (41) et de creux (42), les saillies (41) de la première pince profilée (4, 29, 46, 53) s'engageant dans les creux (42) de l'autre prince profilée (4, 29, 46, 53) en laissant entre eux la fente profilée (43) anti-décharge d'étincelle.

19. Dispositif selon la revendication précédente,
**caractérisé en ce que**
les saillies (41) et les creux (42) de la pince profilée (4, 29, 46, 53) sont configurés sous forme de dents et de creux entre-dents.

20. Dispositif selon la revendication 19,
**caractérisé en ce que**
les dents et les creux entre-dents sont de forme triangulaire.

21. Dispositif selon la revendication 19,
**caractérisé en ce que**
les dents et les creux entre-dents sont de forme rectangulaire, trapézoïdale ou en dents de scie.

22. Dispositif selon l'une des revendications précédentes,
**caractérisé en ce que**
la fente profilée (43) anti-décharge d'étincelle est formée dans une zone de coin de la pince profilée en forme de biais à 45°.

23. Dispositif selon l'une des revendications précédentes,
**caractérisé en ce que**
la zone de coin de la pince profilée est polygonale et présente au moins deux fentes profilées (43) anti-décharge d'étincelle.

24. Dispositif selon l'une des revendications précédentes 3 à 23,
**caractérisé en ce que**
la pince profilée (4, 29, 46, 53) avec la barrette de base (8, 30) et les barrettes latérales (9, 10, 31, 32, 47, 54) est d'une seule pièce d'un même matériau.

25. Dispositif selon l'une des revendications précédentes,
**caractérisé en ce que**
la pince profilée (4, 29, 46, 53) est fixée de manière non amovible à au moins l'une des parties de boîtier (2, 3, 23, 24, 45, 56).
